# EUROPÄISCHE PATENTSCHRIFT

(11) **EP 4 021 688 B1**
(45) Veröffentlichungstag und Bekanntmachung des Hinweises auf die Patenterteilung: **31.07.2024**
(21) Anmeldenummer: 20740204.1
(22) Anmeldetag: 04.06.2020
(51) Int. Cl.: B25J 9/16, H05K 13/08

(54) **VERFAHREN FÜR DIE BESTÜCKUNG EINER MONTAGEPLATTE MIT BESTÜCKUNGSKOMPONENTEN EINER SCHALT- UND/ODER STEUERUNGSANLAGE**
METHOD FOR POPULATING A MOUNTING BOARD WITH ASSEMBLY COMPONENTS OF SWITCHGEAR SYSTEM AND/OR CONTROL SYSTEM
PROCÉDÉ DE REMPLISSAGE D'UNE CARTE DE MONTAGE AVEC DES COMPOSANTS D'ASSEMBLAGE D'UN SYSTÈME D'APPAREILLAGE DE COMMUTATION ET/OU D'UN SYSTÈME DE COMMANDE

(30) Priorität: 29.08.2019 DE 102019123245
(43) Veröffentlichungstag der Anmeldung: 06.07.2022
(73) Patentinhaber: Rittal GmbH & Co. KG, 35745 Herborn (DE)
(72) Erfinder: BÄCHLER, Andreas Michael, 35708 Haiger (DE)
(74) Vertreter: Angerhausen, Christoph
(86) Internationale Anmeldenummer: PCT/DE2020/100468
(87) Internationale Veröffentlichungsnummer: WO 2021/037297

(56) Entgegenhaltungen:
- US-A1- 2015 158 176
- US-B1- 6 360 950
- SCHALTSCHRANKBAU MAGAZIN: "Anlagenbau, Industrie und Gebäude SCHALTSCHRANKBAU Methoden - Komponenten - Workflow - Ausgabe 5 2018", SCHALTSCHRANKBAU MAGAZIN, 1 September 2018 (2018-09-01), XP055720874, Retrieved from the Internet <URL:https://www.schaltschrankbau-magazin.de/downloadbereich/> [retrieved on 20200807]

## Beschreibung

Die Erfindung betrifft ein Verfahren für die Bestückung einer Montageplatte oder dergleichen mit Bestückungskomponenten einer Schalt- und/oder Steuerungsanlage.

Bei der Fertigung von Schalt- und Steuerungsanlagen ist der Prozess der Bestückung der Montageplatte mit Bestückungskomponenten wie Montageschienen, elektrischen Schaltelementen, Kabelkanälen und dergleichen neben der Verdrahtung der Schaltanlage der zentrale und zeitintensivste Arbeitsvorgang, der bis heute mehrheitlich manuell durchgeführt wird. Dabei stellt nicht nur die Komplexität dieses Arbeitsvorgangs sondern vor allem auch der Anspruch einer möglichst fehlerfreien Durchführung große Anforderungen an die die Bestückung vornehmenden Personen.

Die Grundlage für die Konfektionierung der Bestückungskomponenten stellt eine Stückliste der Komponenten oder der Stromlaufplan selbst dar. Insbesondere das manuelle Auslesen der Stückzahlen und Artikelnummern aus dem häufig in Papierformat vorliegenden Stromlaufplan, welcher in der Praxis die häufigste Anleitungsform für die manuelle Bestückung darstellt, ist ein aufwendiger und fehleranfälliger Prozess, da in der Regel ein mehrere hundert Seiten umfassendes Dokument gesichtet werden muss, welches nur mit elektrotechnischem Grundverständnis nachvollzogen werden kann.

Erschwerend kommt hinzu, dass die Mehrheit der benötigten Bestückungskomponenten nicht auftragsbezogen kommissioniert und bereitgestellt werden, sondern am Arbeitsplatz der die Bestückung vornehmenden Person selbst vorgehalten werden müssen, um daraus die benötigten Mengen zu entnehmen. Die die Bestückung vornehmende Person muss dabei eigenverantwortlich den Lagerbestand überwachen und gegebenenfalls in einem Zentrallager Nachschub anfordern.

Die Platzierung und Montage der Bestückungskomponenten auf der Montageplatte erfolgt in den meisten Fällen auf Basis einer Konstruktionszeichnung mit Positionsangaben für Tragschienen, Kabelkanäle sowie jeweils die ersten Komponenten auf einer jeweiligen Tragschiene. Die Platzierung allein auf Grundlage des Schaltplans ist in ca. 20 % der Fälle eine gängige Vorgehensweise. Hierbei ist eine meist langjährige Erfahrung erforderlich, da der Schaltplan keine geometrischen Informationen hinsichtlich der Bestückungskomponenten aufweist, sondern lediglich funktionelle Angaben beinhaltet und somit die Positionierung auf Erfahrungswerten beruht sowie das "Ausprobieren" und manuelles Vorverteilen der Komponenten auf der Montageplatte beinhaltet. Aus diesen Gründen birgt der bisher fast ausschließlich manuell durchgeführte Arbeitsschritt der Bestückung der Montageplatte mit Komponenten mit seinem ca. 25 %igen Anteil an der Gesamtbearbeitungszeit sowohl in qualitativer Hinsicht als auch hinsichtlich der Bearbeitungszeit und der sich daraus ergebenden Kosten erhebliches Verbesserungspotenzial.

Dokumente US2015158176 und US6038336 offenbaren Bestückungsroboter des Stands der Technik.

Es ist daher die Aufgabe der Erfindung, ein Verfahren für die Bestückung einer Montageplatte einer Schalt- und/oder Steuerungsanlage vorzuschlagen, welches zum einen eine hohe Prozesssicherheit gewährleistet und zum anderen kurze Bearbeitungszeiten ermöglicht.

Diese Aufgabe wird durch ein Verfahren mit den Merkmalen des Anspruchs 1 gelöst. Die abhängigen Ansprüche betreffen jeweils vorteilhafte Ausführungsformen der Erfindung.

Die Erfindung macht sich zunutze, dass die Planungsdaten, welche bei der Entwicklung einer Schalt- oder Steuerungsanlage mit Hilfe moderner softwaregestützter Engineering-Systeme, beispielsweise mit einem ECAD- oder MCAD-System, erzeugt werden, bereits sämtliche Informationen in digitalisierter Form vorhalten, welche für die automatisierte Bestückung der Montageplatte erforderlich sind, beispielsweise Positionsdaten, Ausrichtungsdaten, Montageartdaten, Komponentenbauformdaten, Lochbilddaten und dergleichen. Mit Hilfe eines Bestückungsroboters, der beispielsweise ein Knickarmroboter sein kann, können auf Grundlage der zuvor genannten Daten Maschinendaten zur Ansteuerung des Bestückungsroboters erzeugt werden, welche die automatisierte Bestückung der Montageplatte zulassen. Die ohnehin in den Planungsdaten enthaltene Stückliste kann beispielsweise dazu verwendet werden, dem Bestückungsroboter eine Montagreihenfolge vorzugeben. Wenn die Bestückungskomponenten in einer definierten Reihenfolge dem Bestückungsroboter an einer definierten Übergabeposition, die im Eingriffbereich des Bestückungsroboters liegt, zugeführt werden und darüber hinaus die exakte Ausrichtung der zu bestückenden Montageplatte in Bezug auf den Bestückungsroboter bekannt ist, ist eine prozesssichere Bestückung der Montageplatte möglich. Beispielsweise kann aus den Planungsdaten ein Bestückungslayout extrahiert werden, das Positionsdaten hinsichtlich der Bestückungskomponenten aufweist, die für die zur Erzeugung von Maschinendaten zur Ansteuerung des Bestückungsautomaten verwendet werden können.

Die Bestückung der Montagplatte kann auch das Bearbeiten der Montageplatte insoweit umfassen, als dass mit dem Bestückungsroboter bedarfsweise aus den Planungsdaten abgeleitete erforderliche Bearbeitungsschritte an der Montageplatte durchgeführt werden. Beispielsweise können die Planungsdaten ein Bohrlochbild der Montageplatte aufweisen, welches von dem Bestückungsroboter unter Zuhilfenahme eines geeigneten Werkzeuggeräts in die Montageplatte eingebracht werden kann. Es kann auch vorgesehen sein, dass der Bestückungsautomat, insbesondere der Bestückungsroboter, lediglich das Vorhandensein einer vorbereiteten Bearbeitung der Montageplatte überprüft, beispielsweise das Vorhandensein eines Bohrlochbilds.

Ebenso kann ein in der Montageplatte bereits vorhandenes Bohrlochbild von dem Bestückungsroboter auch dazu verwendet werden, die räumliche Ausrichtung und/oder die Position der Montageplatte in Bezug auf den Bestückungsautomaten beziehungsweise den Bestückungsroboter zu erfassen. Dazu kann das Bohrloch mit dem Bildverarbeitungssystem des Bestückungsroboters erfasst und mit einem in den Planungsdaten hinterlegten Bohrlochbild abgeglichen werden, um beispielsweise einen Winkelversatz oder lateralen Versatz der Montageplatte gegenüber einer Sollposition der Montageplatte in Bezug auf den Bestückungsroboter beziehungsweise den Bestückungsautomaten zu ermitteln und bei der Ermittlung der Positionen auf der Montageplatte durch Extraktion entsprechender Positionsdaten aus den Planungsdaten als Offset zu berücksichtigen.

Die Planungsdaten können aus einem Planungssystem, beispielsweise aus einem ECAD-System, bereitgestellt werden. Dabei kann vorgesehen sein, dass in einem ersten Schritt noch vor dem Einlesen der aus dem Planungssystem bezogenen Planungsdaten die Planungsdaten mit einer Prüfroutine auf eine Automatisierungstauglichkeit der in den Planungsdaten hinterlegten Bearbeitungs- und/oder Bestückungsschritte überprüft werden. Das Verfahren kann dabei weiterhin umfassen, dass als nicht automatisierbare Bearbeitungs- oder Bestückungsschritte insoweit optimiert werden, dass sie automatisierbar sind. Beispielsweise können zwei Komponenten, die gemäß den Planungsdaten aus dem Planungssystem zu dicht nebeneinander angeordnet sind, um sie automatisiert mit dem Bestückungsroboter und dessen Endeffektor auf der Montageplatte zu positionieren oder in einem der Bestückung nachfolgenden Verdrahtungsprozess zu verdrahten, weiter auseinander positioniert werden, sofern dies die in den Planungsdaten hinterlegte Gesamtplanung zulässt.

Das Einlesen der Planungsdaten kann durch manuelles Aufrufen oder durch automatische Identifikation mittels Einlesens eines Produktidentifizierungscodes, eines RFID-Chips oder dergleichen erfolgen. Dabei kann vorgesehen sein, dass die Planungsdaten unmittelbar in den Bestückungsautomaten geladen werden. Alternativ kann der Bestückungsautomat IPbasiert an einen externen Server angeschlossen sein, auf welchen gegebenenfalls auch das Planungssystem zugreifen und die Planungsdaten für den Abruf durch den Bestückungsautomaten bereitstellen kann. Es kann vorgesehen sein, dass die Extraktion der für das erfindungsgemäße Verfahren erforderlichen Daten aus den Planungsdaten, beispielsweise die Extraktion von Positionsdaten der auf der Montageplatte zu montierenden Bestückungskomponenten, durch den Bestückungsautomaten selbst durchgeführt wird oder durch einen dezentralen Rechner, welcher beispielsweise auf den zuvor genannten Server Zugriff hat oder auf diesem gehostet ist und auf Anforderung des Bestückungsautomaten über den Server entsprechend extrahierte Daten dem Bestückungsautomaten bereitstellt.

Das Verfahren kann weiterhin vorsehen, dass vor dem Bestücken der Montageplatte mit den Bestückungskomponenten der Bestückungsroboter mit Hilfe seines Bildverarbeitungssystems das in der Montageplatte ausgebildete Bohrlochbild abscannt und die ermittelten Ist-Daten gefundener Bohrungen mit den in den Planungsdaten hinterlegten Soll-Daten für das Bohrlochbild abgleicht.

Die Bestückung der Montageplatte mit Bestückungskomponenten kann insbesondere unter Zuhilfenahme vorkonfektionierter Komponenten, Betriebsmittel und Befestigungselementen erfolgen. Diese lassen sich in die folgenden fünf Hauptgruppen unterteilen: Tragschienen, Kabelkanäle, Klein- und Serienkomponenten, Groß- und Einzelkomponenten sowie Befestigungsmittel wie Schrauben und/oder Nieten. Diese Komponenten können in unterschiedlicher Ausführung bereitgestellt werden, um von dem Bestückungsroboter aufgenommen, positioniert und gegebenenfalls auf der Montageplatte montiert werden zu können. Die Tragschienen und Kabelkanäle können vorkonfektioniert zum Beispiel gestapelt oder aufgereiht auf einem Transportwagen von einem Zuschnittsautomaten dem Bestückungsautomaten zugeführt werden. Alternativ können diese beiden Komponententypen auch direkt an den Bestückungsautomaten prozessbezogen zugeschnitten und einzeln beziehungsweise über einen Puffer bereitgestellt werden von wo aus der Bestückungsroboter die Tragschienen oder Kabelkanäle aufnimmt.

Die Klein- und Serienkomponenten können stationär oder mobil über einen Transportwagen, welcher diverse Magazine beinhaltet, die projektbezogen kommissioniert und anschließend an den Bestückungsautomaten überführt werden, insbesondere in einer definierte Ausrichtung und Position in Bezug auf den Bestückungsroboter angeordnet werden, so dass dieser die in den Magazinen vorgehaltenen Komponenten prozesssicher abnehmen kann. In den Magazinen können die Komponenten insbesondere in einer vorgegebenen Reihenfolge angeordnet sein, die beispielsweise einer aus der Stückliste abgeleiteten vorteilhaften Montagereihenfolge der Bestückungskomponenten entspricht.

Die Groß- und Einzelkomponenten wie Lasttrennschalter und dergleichen können ebenso stationär oder über einen mobilen Transportwagen für den Bestückungsautomaten bereitgestellt werden, welcher wiederum derart beschaffen und in Bezug auf den Bestückungsautomaten angeordnet ist, dass ein prozesssicheres Abnehmen der Komponenten von dem Transportwagen durch den Bestückungsroboter möglich ist.

Die Befestigungsmittel wie Schrauben, Nieten und dergleichen können entweder über einen Fördertopf oder über ein Magazin bereitgestellt beziehungsweise halb- oder vollautomatisch an ein Befestigungswerkzeug des Bestückungsautomaten überführt werden. Beispielsweise kann ein Schraubenmagazin einem elektrischen Schraubwerkzeug zugeführt sein, welches einen Adapter aufweist, über den das Werkzeug an dem Greifer am Endeffektor des Bestückungsroboters adaptierbar ist, so dass der Bestückungsroboter das elektrische Werkzeug prozesssicher in Bezug auf die Montageplatte manövrieren kann, beispielsweise um eine Montageschiene an der Montageplatte zu verschrauben.

Der Bestückungsroboter kann beispielsweise als Knickarmroboter ausgebildet sein. Vorteilhafterweise weist der Bestückungsroboter einen multifunktionalen Endeffektor auf, welcher gleichzeitig sowohl die für die Bestückung erforderliche Handhabung der Bestückungskomponenten als auch die von Werkzeuggeräten erlaubt und dazu insbesondere die erforderlichen Bewegungen ausführen kann, etwa für das Positionieren und Einrasten der Komponenten auf der Montageplatte beziehungsweise auf einer Tragschiene. Beispielsweise kann der multifunktionale Endeffektor so gestaltet sein, dass er die diversen Bestückungskomponenten als auch ein Bohrmodul sowie ein Befestigungssystem aufnehmen, handhaben und auf der Montageplatte bedarfsweise platzieren kann. Zusätzlich kann sich am Endeffektor das Bildverarbeitungssystem befinden. Dieses kann beispielsweise eine Kamera oder einen Scanner aufweisen, welcher die Orientierung und/oder die Position der Montageplatte sowie etwaige Bohrungen und Ausbrüche und (bereits bestückte) Komponenten auf der Montageplatte oder auf Breitstellungseinheiten, wie Transportwagen, identifizieren kann.

Zum Greifen und Fixieren der unterschiedlichen Bestückungskomponenten kann ein Endeffektor eingesetzt werden, der ein kraft- und/oder weggesteuertes Greifmodul einsetzt. Dadurch wird erreicht, dass die von dem Greifmodul während des Bestückungsprozesses zu greifenden Bestückungskomponenten, welche sich insbesondere hinsichtlich ihrer Geometrie erheblich voneinander unterscheiden können, nicht einzeln eingelernt werden müssen, sondern individuell gegriffen werden können, wobei diese unabhängig von ihrer Größe mit einer Mindestkraft beaufschlagt werden können, wodurch eine prozesssichere Handhabung und Befestigung ermöglicht wird. Mit dem Bestückungsroboter kann insbesondere dann, wenn er als Knickarmroboter mit einem multifunktionalen Endeffektor der zuvor beschriebenen Art ausgestattet ist, erreicht werden, dass die Bestückung der Komponenten sowohl in vertikaler Richtung von oben, in horizontaler Richtung von der Seite, als auch in einer schrägen Anstellung in einem zwischen der Horizontalen und der Vertikalen liegenden Winkelbereich erfolgen kann.

Nach der Platzierung beziehungsweise Montage einer Bestückungskomponente auf der Montageplatte kann vorgesehen sein, dass eine Funktions- und Qualitätskontrolle durch Überwachung einer definierten Abzugskraft und/oder durch die zusätzliche Kontrolle eines definierten Drehmoments bei Schraubprozessen beziehungsweise der Abzugskraft bei Nietprozessen erfolgt.

Das Erfassen der räumlichen Ausrichtung und/oder einer Position der Montageplatte kann das Erfassen einer Ausrichtung und/oder einer Position mindestens eines Bohrlochs, mindestens eines Bohrlochbildes, oder mindestens eines Ausbruchs in der Montageplatte und das Abgleichen mindestens einer dabei erfassten Ausrichtung und/oder Position mit einer aus den Planungsdaten extrahierten Sollvorgabe aufweisen.

Mindestens ein Bohrloch, mindestens ein Bohrlochbild, oder mindestens ein Ausbruch kann mit dem Bestückungsroboter in die Montageplatte eingebracht werden, wenn bei dem Abgleichen abweichend von der Sollvorgabe mindestens ein fehlendes Bohrloch, ein fehlendes Bohrlochbild, oder ein fehlender Ausbruch erfasst worden ist.

Das Verfahren kann weiterhin das Einbringen mindestens eines Bohrlochs, mindestens eines Bohrlochbilds, oder mindestens eines Ausbruchs in die Montageplatte mit dem Bestückungsroboter aufweisen. Dazu kann der Bestückungsroboter mit einem Greifer an seinem Endeffektor ein Werkzeuggerät von einer der Montageplatte beigeordneten Referenzposition abnehmen. Das Werkzeuggerät kann beispielsweise ein elektrisch angetriebener Bohrer sein. Das Werkzeuggerät kann beispielsweise eine Handbohrmaschine oder eine Oberfräse sein, die mit einem an das Bohrmaschinen- beziehungsweise Fräsengehäuse angeformten Adapter ausgestattet ist, um von dem Greifer prozesssicher in Eingriff genommen und geführt werden zu können.

Der Bestückungsroboter kann das von der Referenzposition abgenommene Werkzeuggerät einer Position auf der Montageplatte zuführen, der über die Planungsdaten mindestens ein Bearbeitungsschritt zugeordnet ist, beispielsweise die Einbringung mindestens eines Bohrlochs, mindestens eines Bohrlochbildes, oder mindestens eines Ausbruchs in die Montagplatte. Dabei kann der Bestückungsroboter mit dem Werkzeuggerät den mindestens einen Bearbeitungsschritt ausführen. Dies kann neben der räumlichen Führung des Werkzeuggeräts in Bezug auf die Montageplatte auch das Ansteuern des Werkzeuggeräts umfassen, beispielsweise das Aktivieren oder Deaktivieren eines Antriebs des Werkzeuggeräts.

Das Verfahren kann weiterhin das Extrahieren einer Stückliste von Bestückungskomponenten aus den Planungsdaten und das Bereitstellen mindestens einer der in der Stückliste enthaltenen Bestückungskomponenten an einer Komponentenzuführung, die im Zugriffsbereich des Bestückungsroboters angeordnet ist, aufweisen.

Weiterhin kann das Verfahren das Aufnehmen der Bestückungskomponente aus dem Zugriffsbereich mit einem Greifer am Endeffektor des Bestückungsroboters und das Kennzeichnen der aufgenommenen Bestückungskomponente mit einer eindeutigen Kennzeichnung aufweisen, die aus den Planungsdaten, vorzugsweise aus einer Stückliste der Planungsdaten, extrahiert wird.

Das Bereitstellen mindestens einer der in der Stückliste enthaltenen Bestückungskomponenten kann das Bereitstellen einer Vielzahl baugleicher Bestückungskomponenten aufweisen, von denen eine Einzige von dem Bestückungsroboter aufgenommen und mit einer eindeutigen Kennzeichnung versehen wird. Anstelle von baugleichen Bestückungskomponenten können auch magazinierte Bestückungskomponenten unterschiedlicher Bauart vorgesehen sein, wobei die Bestückungskomponenten in dem Magazin gerade in einer Bestückungsreihenfolge angeordnet sind, die einer Reihenfolge entspricht, in welcher der Bestückungsautomat die Komponenten auf der Montageplatte positioniert.

Für das Kennzeichnen kann die betreffende Bestückungskomponente von dem Bestückungsroboter auf einer Beschriftungseinheit abgelegt werden. Dabei kann das Verfahren, das optisch auslesbare Beschriften der Bestückungskomponente mit der Beschriftungseinheit, und nach dem Beschriften das Wiederaufnehmen der Bestückungskomponente mit dem Bestückungsroboter von der Beschriftungseinheit aufweisen.

Die Bestückungskomponente kann nach dem Bereitstellen, dem Aufnehmen und dem Kennzeichnen von dem Bestückungsroboter auf der Montageplatte platziert werden. Dazu kann vorgesehen sein, dass aus den Planungsdaten über die eindeutige Kennzeichnung der Bestückungskomponente zugeordnete Positionsdaten extrahiert werden.

Die Bestückungskomponente kann nach dem Platzieren von dem Greifer am Endeffektor des Bestückungsroboters freigegeben werden, woraufhin der Bestückungsroboter mit dem Greifer ein Befestigungswerkzeuggerät, etwa einen elektrisch angetriebenen Schrauber oder ein Nietgerät, von einer Geräteabnahmeposition abnimmt, in dem der Bestückungsroboter das Befestigungswerkzeuggerät mit dem Greifer greift oder über ein Wechselsystem, wie zum Beispiel eine Schnellwechselkupplung, aufnimmt und mindestens einer Befestigungsposition auf der Montageplatte zuführt, wozu der Bestückungskomponente zugeordnete Montagepositionsdaten aus den Planungsdaten extrahiert werden.

Das Bereitstellen mindestens einer der in der Stückliste enthaltenen Bestückungskomponenten kann das Bereitstellen einer Montageschiene aufweisen, die mit dem Bestückungsroboter von der Komponentenzuführung abgenommen, an einer Montageposition auf der Montageplatte platziert und an der Montageposition auf der Montageplatte montiert wird. Dabei kann anschließend daran mindestens eine weitere in der Stückliste enthaltene Bestückungskomponente von dem Bestückungsroboter von der Komponentenzuführung abgenommen und an der auf der Montageplatte montierten Montageschiene montiert, vorzugsweise auf der Montageschiene aufgerastet werden. Es kann auch vorgesehen sein, dass zunächst nacheinander sämtliche Montageschiene, etwa Hutschienen, auf der Montageplatte an ihrer Montageposition platziert und erst danach die Montageschienen auf der Montageplatte montiert werden.

Es kann vorgesehen sein, dass der weiteren Bestückungskomponente zugeordnete weitere Montagepositionsdaten aus den Planungsdaten extrahiert werden, die eine Montageposition der weiteren Bestückungskomponente entlang der Montageschiene vorgeben. Dabei können für das Montieren der weiteren Bestückungskomponente an der Montageschiene aus den Planungsdaten der Bestückungskomponente zugeordnete Bewegungsdaten extrahiert werden, durch die eine von dem Bestückungsroboter auszuführende Montagebewegung für das Montieren der weiteren Bestückungskomponente an der Montageschiene vorgegeben sind.

Die Bestückungskomponente kann als Stangen- oder Endlosware bereitgestellt und beispielsweise ein Kabelkanal oder eine Montageschiene, etwa eine Hutschiene, sein, wobei das Verfahren das Ablängen der Bestückungskomponente aufweist, wozu aus den Planungsdaten Längendaten für eine auf der Montageplatte zu montierende Bestückungskomponente extrahiert werden. Die Bestückungskomponente kann nach dem Ablängen an einer Komponentenzuführung, die im Zugriffsbereich des Bestückungsroboters angeordnet ist, für das Abnehmen durch den Bestückungsroboter bereitgestellt werden.

Nach dem Ausführen des mindestens einen Bearbeitungs- oder Bestückungsschrittes sowie einer diesbezüglichen Qualitätsprüfung kann ein Ergebnis der Qualitätsprüfung in den Planungsdaten hinterlegt und über die Positionsdaten der Planungsdaten eindeutig der überprüften Bestückungskomponente oder der überprüften Bearbeitungsposition zugeordnet werden.

Vorzugsweise werden zumindest sämtliche Bestückungskomponenten- und Werkzeugbewegungen von dem Bestückungsroboter während des gesamten Verfahrens mit demselben Endeffektor und Greifer des Bestückungsroboters durchgeführt, wozu der Greifer zwei zueinander verstellbare Greiferbacken aufweisen kann, vorzugsweise zwei linear zueinander verstellbare plattenförmige Greiferbacken, die das jeweils abzunehmende Element durch Verstellen der Greiferbacken zueinander einklemmen. Um das prozesssichere Abnehmen sicherzustellen, kann vorgesehen sein, dass das abzunehmende Element, beispielsweise eine Bestückungskomponente, ein Werkzeuggerät oder dergleichen, mit einem Adapter in einen Griffbereich der zueinander verstellbaren Greiferbacken eingreift.

Weitere Einzelheiten der Erfindung werden anhand der nachstehenden Figuren erläutert. Dabei zeigt:
- Figur 1: eine schematische Übersicht zur Veranschaulichung einer Ausführungsform des erfindungsgemäßen Verfahrens;
- Figur 2: in schematischer Darstellung ein Ablaufdiagramm der Bestückung einer Montageplatte mit Bestückungskomponenten;
- Figur 3: eine beispielhafte Ausführungsform eines multifunktionalen Greifers zur Verwendung in einem erfindungsgemäßen Verfahren;
- Figur 4: die Anwendung des Greifers gemäß Figur 3 zur Manövrierung einer Montageschiene; und
- Figur 5: die Verwendung des Greifers gemäß Figur 3 zur Manövrierung einer Reihenanschlussklemme.

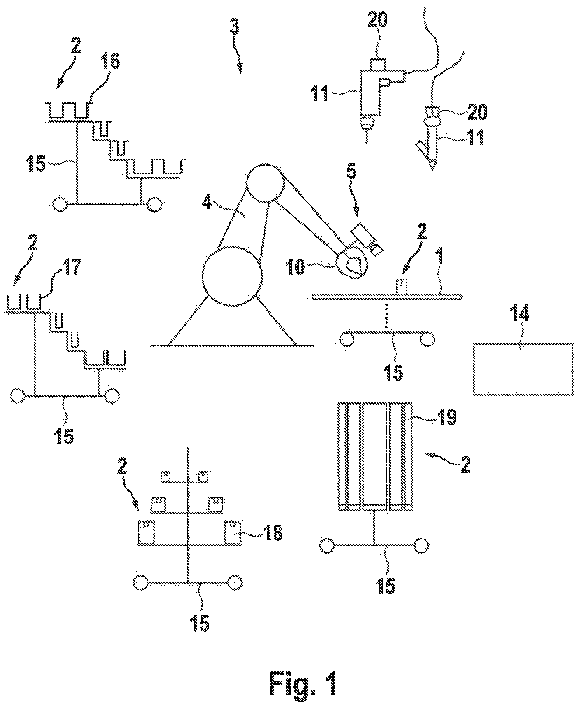

Die Figur 1 zeigt einen schematischen Systemaufbau zur Implementierung des erfindungsgemäßen Verfahrens gemäß einer Ausführungsform der Erfindung. Demgemäß kann ein Bestückungsautomat 3 einen Bestückungsroboter 4 aufweisen, der vorliegend als ein Knickarmroboter ausgebildet ist und an seinem Greiferende einen multifunktionalen Endeffektor 10 sowie ein Bildverarbeitungssystem 5 aufweist. Das Bildverarbeitungssystem 5 kann eine Kamera, einen Scanner oder eine andere elektromagnetische Messvorrichtung, insbesondere eine Vorrichtung zur optischen Erfassung der Oberfläche der Montageplatte 1 und gegebenenfalls darauf angeordneter Bestückungskomponenten 2 beziehungsweise darin eingebrachter Löcher und Ausbrüche aufweisen.

Die Montageplatte 1 wird mit einem Transportwagen 15 vorzugsweise in der Horizontalen ausgerichtete dem Bestückungsautomaten 3 zugeführt. Beispielsweise kann der Transportwagen 15 dazu eingerichtet sein, dass mit ihm die unterstützte Demontage der Montageplatte aus einem vormontierten Schaltschrank möglich ist, ohne dass dazu die Last der Montageplatte 1 von einer die Überführung der Montage durchführenden Person gehalten werden muss. Demgemäß kann vorgesehen sein, dass der Transportwagen 15 über geeignete Halter und Befestigungsmittel verfügt, mit Hilfe welcher die Montageplatte 1 aus dem Schaltschrank entnommen und an dem Transportwagen 15 befestigt werden kann. Nach der Entnahme der vertikal im Schaltschrank montierten Montageplatte 1 aus dem Schaltschrank kann die Montageplatte 1 mit dem Transportwagen 15 in die in Figur 1 gezeigte Horizontale verschwenkt und dem Bestückungsautomaten 3 zugeführt werden. Nachdem die Montageplatte 1 die Bestückung mit Bestückungskomponenten 2 unter Verwendung des Bestückungsautomaten 3 erfahren hat, kann sie mit dem Transportwagen 15 wieder in den Schaltschrank eingeführt und dort gegebenenfalls manuell oder teilautomatisch fixiert werden. Für das vollständige Handling der Montageplatte 1 von der Entnahme der Montageplatte 1 aus dem Schaltschrank bis zur Zurückführung der Montageplatte 1 in den Schaltschrank kann die Montageplatte 1 permanent mit dem Transportwagen 15 gehalten und manövriert werden, so dass auch insofern kein kräftezehrendes manuelles Handling der Montageplatte 1 erforderlich ist.

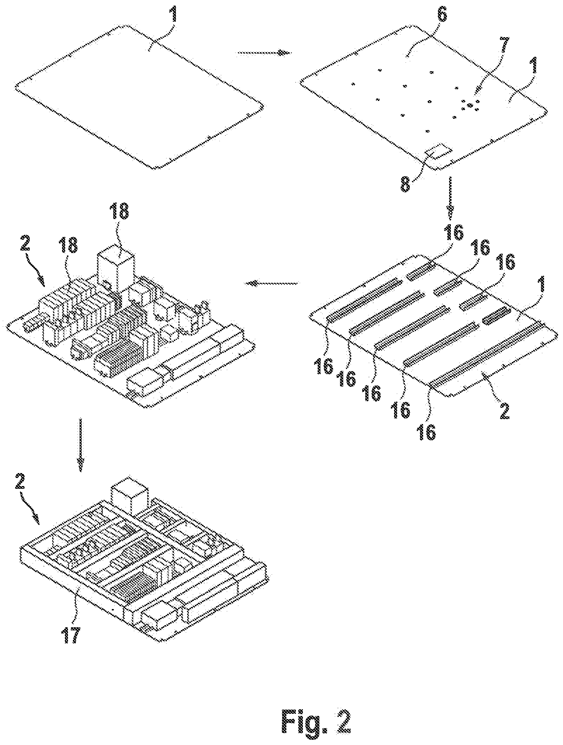

In der Zusammenschau der Figuren 1 und 2 ist der Bestückungsprozess veranschaulicht. Nachdem die Montageplatte 1 in der zuvor beschriebenen Art in die Horizontale gebracht und dem Bestückungsautomaten 3 und insbesondere dem Bestückungsroboter 4 des Bestückungsautomaten 3 zugeführt worden ist, kann der Bestückungsroboter 4 in einem ersten Verarbeitungsschritt die exakte Ausrichtung der Montageplatte 1 in Bezug auf den Roboter 4 prüfen, so dass das Handling der Montageplatte 1 auch insoweit erleichtert wird, als dass es nicht zwingend erforderlich ist, die Montageplatte 1 manuell in eine präzise, definierte Position zu schaffen, um eine prozesssichere Bearbeitung oder Bestückung der Montageplatte 1 zu ermöglichen.

Die Erfassung der Ausrichtung der Montageplatte 1 in Bezug auf den Bestückungsroboter 4 kann beispielsweise unter Verwendung des Bildverarbeitungssystems 5 am Endeffektor 10 des Bestückungsroboters 4 erfolgen, indem dieses beispielsweise ein Bohrlochbild oder eine andere optisch erfassbare prägnante Kontur an der Oberseite der Montageplatte 1 optisch erfasst und durch Bildverarbeitung eine Soll-Ausrichtung der Montageplatte 1 mit einer Ist-Ausrichtung der Montageplatte 1 vergleicht und daraus gegebenenfalls ein Offset berechnet.

Die Soll-Ausrichtung der Montageplatte 1 sowie sämtliche darüber hinaus für die Bestückung der Montageplatte 1 erforderlichen Planungsdaten können direkt aus einem Planungssystem, beispielsweise aus einem ECAD-System und/oder aus einem MCAD-System bereitgestellt werden. Die Soll-Ausrichtung der Montageplatte 1 kann von dem Planungssystem dem Bestückungsautomaten 3 direkt oder indirekt (über einen Server beziehungsweise cloudbasiert) unter Zugrundelegung der bereitgestellten Planungsdaten ermittelt werden. Die Planungsdaten können beispielsweise ein Soll-Bohrlochbild enthalten, welches in der zuvor beschriebenen Weise mit einem von dem Bildverarbeitungssystem 5 erfassten Ist-Bohrbild zur Bestimmung der Ausrichtung der Montageplatte 1 in Bezug auf den Bestückungsroboter 4 abgeglichen wird.

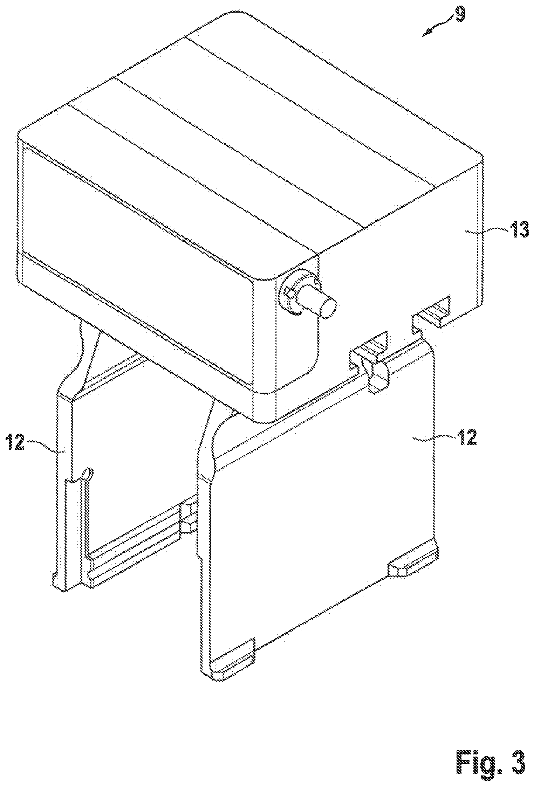

Bevor die eigentliche Bestückung der Montageplatte 1 mit Bestückungskomponenten 2 beginnt, kann vorgesehen sein, dass das zu bestückende Projekt mit einer Prüfroutine auf seine Automatisierungstauglichkeit überprüft und gegebenenfalls manipuliert wird, sollte sich mindestens ein Bestückungsschritt bei der Überprüfung herausstellen, welcher nicht automatisierbar ist, beispielsweise weil der Bestückungsroboter 4, insbesondere der Endeffektor 10 mit seinem Greifer 9 für den betreffenden Bestückungsschritt ungeeignet ist. Die Optimierung kann insbesondere dahingehend erfolgen, dass sämtliche Bestückungsschritte zumindest weitestgehend mit demselben Endeffektor 10, insbesondere mit demselben Greifer 9 am Ende des Endeffektors 10 (vgl. Figuren 3 bis 5) durchgeführt werden können, so dass am Ende des Prozesses tatsächlich eine im Wesentlichen vollständig bestückte Montageplatte 1 bereitgestellt ist, welche keine oder allenfalls sehr geringfügige manuelle Nacharbeit erfordert. Die Optimierung des Bestückungsprozesses kann durch den Bestückungsautomaten 3 selbst erfolgen oder dezentral auf einem Server, beispielsweise cloudbasiert, auf welchen sowohl das ECAD-System oder ein anderes Planungssystem als auch der Bestückungsautomat 3 zugreifen können.

Die Bestimmung der relativen Ausrichtung der Montageplatte 1 in Bezug auf den Bestückungsautomaten 3 und insbesondere den Bestückungsroboter 4 kann umfassen, dass die gesamte Oberfläche der Montageplatte 1 optisch erfasst wird, beispielsweise abgescannt wird, so dass in demselben Arbeitsschritt das vollständige auf der Montageplatte gegebenenfalls bereits ausgebildete Lochbild, welches beispielsweise Bohrlöcher, Ausbrüche und dergleichen für die Montage von Bestückungskomponenten aufweisen kann, erfasst wird. Das im Rahmen der vollständigen Erfassung der Montageplatte 1 bestimmte Lochbild kann mit entsprechenden Lochbilddaten verglichen werden, die aus den Planungsdaten extrahiert werden können. Auch dieser Extraktionsprozess kann wiederum durch den Bestückungsautomaten 3 selbst erfolgen oder dezentral auf einem Server, beispielsweise cloudbasiert, auf welchen der Bestückungsautomat 3 Zugriff hat. Sollte die Überprüfung ergeben, dass ein Bohrloch, ein Ausbruch oder eine sonstige mechanische Bearbeitung der Montageplatte 1, welche gemäß den installierten Lochbilddaten vorhanden sein sollte, nicht vorhanden ist, so kann dieses Loch beziehungsweise dieser Ausbruch durch einen von dem Bestückungsautomaten 3 durchgeführten Bearbeitungsschritt in die Montageplatte 1 eingebracht werden. Dazu kann der Bestückungsroboter 4 mit seinem Endeffektor 10 von einer Werkzeugübergabeschnittstelle des Bestückungsautomaten 3 ein geeignetes Werkzeuggerät 11 abnehmen, zu der Montageplatte 1 führen und das Werkzeuggerät 11 derart ansteuern, dass die erforderliche Bearbeitung der Montageplatte 1 vorgenommen wird. Die Werkzeuggeräte 11 können beispielsweise aus dem Stand der Technik bekannte Handbearbeitungsgeräte sein, beispielsweise eine Handbohrmaschine, welche an ihrem Gehäuse einen angeformten oder nachträglich montierten Adapter 20 aufweist, welcher kompatibel mit dem Greifer 9 (vgl. Figuren 3 bis 5) des Endeffektors 10 ist, so dass der Bestückungsroboter 4 das Werkzeuggerät 11 prozesssicher handhaben kann.

Nachdem gegebenenfalls durch ein erneutes Abscannen der Montageplattenoberseite mit dem Bildverarbeitungssystem 5 verifiziert wurde, dass das in die Montageplatte 1 eingebrachte Ist-Lochbild einem Soll-Lochbild gemäß den Lochbilddaten aus den Planungsdaten entspricht, kann der eigentliche Bestückungsprozess der Montageplatte 1 beginnen. Die automatisierte Bestückung der Montageplatte 1 kann unter Zuhilfenahme vorkonfektionierter Komponenten/Betriebsmittel und Befestigungselemente erfolgen. Wie in Figur 1 dargestellt ist, können die Komponenten 2 beispielsweise unter Verwendung von Transportwagen 15 dem Bestückungsautomaten 3 beigeordnet werden, so dass der Bestückungsroboter 4 die Komponenten 2 prozesssicher von dem jeweiligen Transportwagen 15 abnehmen kann. Kleinteilige Bestückungskomponenten 2, beispielsweise Reihenanschlussklemmen, können in Magazinen 19 magaziniert bereitgestellt werden.

Die Bestückungskomponenten 2 können beispielsweise in die folgenden fünf Hauptgruppen unterteilt werden: Tragschienen, Kabelkanäle, Klein- und Serienkomponenten, Groß- und Einzelkomponenten sowie Befestigungsmittel, wie Schrauben, Nieten und dergleichen. Die Tragschienen und Kabelkanäle können beispielsweise vorkonfektioniert, zum Beispiel gestapelt oder aufgereiht, auf dem Transportwagen von einer entsprechenden Zuschnittsanlage für den Zuschnitt von Tragschienen und/oder Kabelkanälen zu dem Bestückungsautomaten 3 überführt werden. Alternativ können insbesondere Tragschienen und Kabelkanäle auch direkt an dem Bestückungsautomaten 3 prozessbezogen aus Stangen- oder Endlosware zugeschnitten und einzeln oder über einen Puffer an einer Übergabeschnittstelle, von welcher der Bestückungsroboter 4 die jeweilige Komponente 4 abnehmen kann, bereitgestellt werden. Analog können die Klein- und Serienkomponenten stationär oder mobil über einen Transportwagen 15 der diverse Magazine 19 aufweist im Wareneingang bestückt beziehungsweise kommissioniert und anschließend an den Bestückungsautomaten 3 überführt und gegebenenfalls zwecks definierter Ausrichtung der Magazine 19 in Bezug auf den Bestückungsautomaten 3 an diesem angekoppelt beziehungsweise festgelegt werden. Die Groß- und Einzelkomponenten können ebenfalls stationär oder über einen mobilen Transportwagen 15 bereitgestellt werden, welcher zum Beispiel verschiedene Ebenen aufweist und somit die Möglichkeit zum Abgreifen mit dem Endeffektor 10 bietet.

Die Befestigungsmittel wie Schrauben, Nieten und dergleichen werden entweder über einen Fördertopf oder über ein Magazin bereitgestellt beziehungsweise halb- oder vollautomatisch an das Befestigungssystem überführt. Beispielsweise kann eines der Werkzeuggeräte 11 als ein Elektroschrauber ausgebildet sein, dem geeignete Schrauben über ein Schraubenmagazin zugeführt sind.

Darüber hinaus weist der in Figur 1 gezeigte Bestückungsautomat 3 eine Beschriftungseinheit 14 auf, welche die individuelle Kennzeichnung der Bestückungskomponenten ermöglicht.

Beispielsweise kann die Beschriftungseinheit 14 einen Beschriftungslaser aufweisen. So ist es beispielweise möglich, dass der Bestückungsroboter 4 eine Bestückungskomponente 2, beispielsweise eine Reihenanschlussklemme aus dem Magazin 19 entnimmt, welche gemäß einer aus den Planungsdaten extrahierten Stückliste eine nächste zu montierende Komponente der auf der Montageplatte 1 zu erstellenden Schalt- und/oder Steueranlage ist. Die aus dem Magazin 19 entnommene Komponente kann von dem Bestückungsroboter 4 vor der Montage auf der Montageplatte 1 auf der Beschriftungseinheit 14 abgelegt werden oder dieser angenähert werden, woraufhin die Komponente von der Beschriftungseinheit 14 eine individuelle Kennzeichnung erhält, welche entweder durch die Planungsdaten vorgegeben ist oder von dem Bestückungsautomaten 3 selbst erzeugt und anschließend in den Planungsdaten hinterlegt wird. Nach der Beschriftung der Bestückungskomponente 2 kann diese dann von dem Bestückungsroboter 4 auf der Montageplatte 1 montiert werden.

Das erfindungsgemäße Verfahren erlaubt es insbesondere, dass abweichend von den aus dem Stand der Technik bekannten Prozessen beispielsweise eine Hutschiene zur Montage von Reihenanschlussklemmen auf der Montageplatte 1 montiert wird, noch bevor die Reihenanschlussklemmen auf der Hutschiene montiert werden. Dies hat insbesondere den Vorteil, dass für das Handling und die Befestigung der Hutschiene auf der Montageplatte 1 kein Freiraum an den gegenüberliegenden Enden der Hutschiene freigelassen werden muss, um das nachträgliche Verschrauben der Hutschiene mit der Montageplatte 1 zu ermöglichen. Stattdessen kann durch das erfindungsgemäße Verfahren die Hutschiene, da sie bereits an der Montageplatte fixiert ist, über ihre gesamte Länge mit Bestückungskomponenten, beispielsweise mit Reihenanschlussklemmen, bestückt werden, so dass eine bessere Ausnutzung der Montagefläche der Montageplatte 1 erreicht wird. Das vorgenannte Prinzip ist auf andere schienenbasierte Montagesysteme, die im Schaltanlagenbau üblicherweise verwendet werden, übertragbar und insbesondere nicht auf Hutschienen zur Montage von Reihenanschlussklemmen beschränkt.

Beispielsweise kann eine Montageschiene von dem Transportwagen 15 abgenommen, auf die Beschriftungseinheit 14 aufgelegt und nach dem Beschriften von der Beschriftungseinheit 14 auf der Montageplatte 1 entsprechend den Planungsdaten, insbesondere den Positionsdaten der Planungsdaten, positioniert und mit der Montageplatte 1 verschraubt oder anderweitig auf dieser befestigt werden. Nachdem die Montageschiene 16 auf der Montageplatte 1 befestigt worden ist, kann mit dem Bestückungsroboter 4 beispielweise eine Reihenanschlussklemme aus dem Magazin 19 entnommen, mit Hilfe der Beschriftungseinheit 14 beschriftet und daraufhin auf der Montageschiene 16, die insbesondere eine Hutschiene sein kann, verrastet werden. Die in dem Magazin 19 aufgenommenen Bestückungskomponenten 2 können beispielsweise in einer definierten Reihenfolge vorkonfektioniert sein, welche einer Reihenfolge der Bestückungskomponenten entspricht, mit welcher sie auf der Montageschiene 16 befestigt werden. Diese Magazinierung ist insbesondere dann zweckmäßig, wenn auf der Hutschiene nicht nur gleichartige Bestückungskomponenten aufgereiht sein sollen, sondern sich baulich unterscheidende. Baulich gleichartige Komponenten erhalten ihre Individualisierung ausschließlich mit Hilfe der Beschriftungseinheit 14.

Nachdem die Montageplatte 1 mit Montageschienen 16 und darauf befestigten elektrischen Komponenten 18 versehen worden ist, können in analoger Weise Kabelkanäle 17 auf der Montageplatte montiert werden.

Die Figuren 3 bis 5 zeigen eine bespielhafte Ausführungsform eines Greifers 9, der für einen Endeffektor 10 (siehe Figur 1) verwendet werden kann und sich insbesondere dadurch auszeichnet, dass er für das Handling unterschiedlichster Bestückungskomponenten sowie Werkzeuggeräte geeignet ist. Dieser weist im Wesentlichen eine Verstelleinheit 13 auf, die eine Linearstelleinheit sein kann, und mit Hilfe welcher zwei Greiferbacken 12, die plattenförmig ausgebildet sein können, zueinander verstellbar sind, insbesondere linear verstellbar.

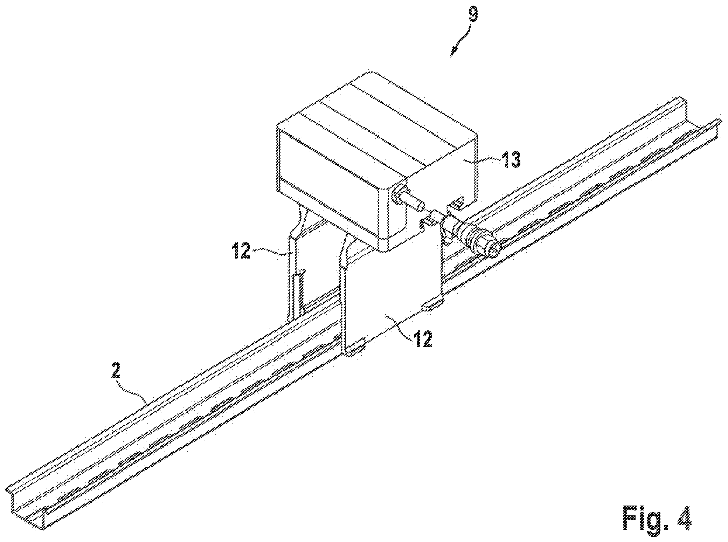

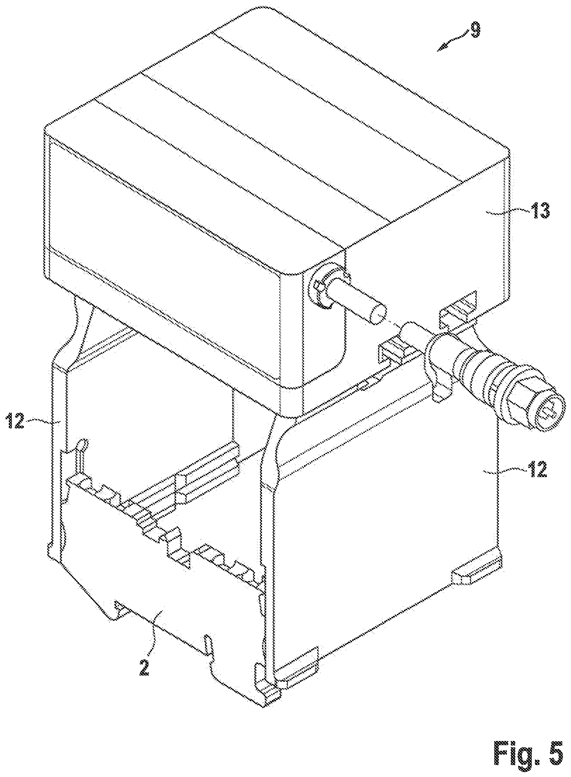

Die Figuren 4 und 5 zeigen, dass mit Hilfe der an den gegenüberliegenden Innenseiten der Greiferbacken 12 ausgebildeten Konturen das Handling unterschiedlichster Komponenten ermöglicht wird, beispielsweise einerseits das Handling von Montageschienen wie Hutschienen (siehe Figur 4) oder das Handling von elektrischen Komponenten, wie Leiteranschlussklemmen (siehe Figur 5).

### Bezugszeichenliste:

- 1: Montageplatte
- 2: Bestückungskomponente
- 3: Bestückungsautomat
- 4: Bestückungsroboter
- 5: Bildverarbeitungssystem
- 6: Bohrloch
- 7: Bohrlochbild
- 8: Ausbruch
- 9: Greifer
- 10: Endeffektor
- 11: Werkzeuggerät
- 12: Greiferbacke
- 13: Verstelleinheit
- 14: Beschriftungseinheit
- 15: Transportwagen
- 16: Montageschiene
- 17: Kabelkanal
- 18: elektrische Komponente
- 19: Magazin
- 20: Adapter

## Patentansprüche

1. Verfahren für die Bestückung einer Montageplatte (1) mit
Bestückungskomponenten (2) einer Schalt- und/oder Steuerungsanlage, das die Schritte aufweist:
- Einlesen von Planungsdaten einer Schalt- und/oder Steuerungsanlage in einen Bestückungsautomaten (3), der einen Bestückungsroboter (4) aufweist;
- Extrahieren von Positionsdaten mindestens einer auf der Montageplatte (1) zu montierenden Bestückungskomponente (2) und/oder mindestens einer Bearbeitungsposition der Montageplatte (1) aus den Planungsdaten;
- Erfassen einer räumlichen Ausrichtung und/oder einer Position der Montageplatte (1) mit einem Bildverarbeitungssystem (5) des Bestückungsroboters (4);
- Zuordnen der Positionsdaten zu mindestens einer Position auf der Montageplatte (1); und
- Ausführen mindestens eines über die Planungsdaten mit der Position auf der Montageplatte (1) verknüpften Bearbeitungs- oder Bestückungsschrittes an der Position auf der Montageplatte (1) mit dem Bestückungsroboter (4), wobei das Erfassen das Erfassen einer Ausrichtung und/oder einer Position mindestens eines Bohrloches (6), mindestens eines Bohrlochbildes (7), oder mindestens eines Ausbruchs (8) in der Montageplatte (1) und das Abgleichen mindestens einer dabei erfassten Ausrichtung und/oder Position mit einer aus den Planungsdaten extrahierten Sollvorgabe aufweist, **dadurch gekennzeichnet, dass**
mindestens ein Bohrloch (6), mindestens ein Bohrlochbild (7), oder mindestens ein Ausbruch (8) mit dem Bestückungsroboter (4) in die Montageplatte (1) eingebracht wird, wenn bei dem Abgleichen abweichend von der Sollvorgabe mindestens ein fehlendes Bohrloch (6), ein fehlendes Bohrlochbild (7), oder ein fehlender Ausbruch (8) erfasst worden ist.

2. Verfahren nach Anspruch 1, das das Einbringen mindestens eines Bohrlochs (6), mindestens eines Bohrlochbilds (7), oder mindestens eines Ausbruchs (8) in die Montageplatte (1) mit dem Bestückungsroboter (4) aufweist, wozu der Bestückungsroboter (4) mit einem Greifer (9) an seinem Endeffektor (10) ein Werkzeuggerät (11) von einer der Montageplatte (1) beigeordneten Referenzposition abnimmt.

3. Verfahren nach Anspruch 2, bei dem der Bestückungsroboter (4) das von der Referenzposition abgenommene Werkzeuggerät (11) einer Position auf der Montageplatte (1) zuführt, der über die Planungsdaten mindestens ein Bearbeitungsschritt zugeordnet ist, vorzugsweise die Einbringung mindestens eines Bohrlochs (6), mindestens eines Bohrlochbilds (7), oder mindestens eines Ausbruchs (8) in die Montageplatte (1), und bei dem der Bestückungsroboter (4) mit dem Werkzeuggerät (11) den mindestens einen Bearbeitungsschritt ausführt.

4. Verfahren nach einem der vorangegangenen Ansprüche, das das Extrahieren einer Stückliste von Bestückungskomponenten (2) aus den Planungsdaten und das Bereitstellen mindestens einer der in der Stückliste enthaltenen Bestückungskomponenten (2) an einer Komponentenzuführung aufweist, die im Zugriffsbereich des Bestückungsroboters (4) angeordnet ist.

5. Verfahren nach Anspruch 4, das das Aufnehmen der Bestückungskomponente (2) aus dem Zugriffsbereich mit einem Greifer (9) am Endeffektor (10) des Bestückungsroboters (4) und das Kennzeichnen der aufgenommenen Bestückungskomponente (2) mit einer eindeutigen Kennzeichnung aufweist, die aus den Planungsdaten, vorzugsweise aus der Stückliste, extrahiert wird.

6. Verfahren nach Anspruch 4 oder 5, bei dem das Bereitstellen mindestens einer der in der Stückliste enthaltenen Bestückungskomponenten (2) das Bereitstellen einer Vielzahl baugleicher Bestückungskomponenten (2) aufweist, von denen eine einzige von dem Bestückungsroboter (4) aufgenommen und mit einer eindeutigen Kennzeichnung gekennzeichnet wird.

7. Verfahren nach Anspruch 5 oder 6, bei dem das Kennzeichnen das Ablegen der Bestückungskomponente (2) auf einer Beschriftungseinheit (14) mit dem Bestückungsroboter (4) und das optisch auslesbare Beschriften der Bestückungskomponente (2) mit der Beschriftungseinheit (14) und nach dem Beschriften das Wiederaufnehmen der Bestückungskomponente (2) mit dem Bestückungsroboter (4) von der Beschriftungseinheit (14) aufweist.

8. Verfahren nach einem der Ansprüche 5 bis 7, bei dem die Bestückungskomponente (2) nach dem Bereitstellen, dem Aufnehmen und dem Kennzeichnen von dem Bestückungsroboter (4) auf der Montageplatte (1) platziert wird, wozu aus den Planungsdaten über die eindeutige Kennzeichnung der Bestückungskomponente (2) zugeordnete Positionsdaten extrahiert werden.

9. Verfahren nach Anspruch 8, bei dem die Bestückungskomponente (2) nach dem Platzieren von dem Greifer (9) am Endeffektor (10) des Bestückungsroboters (4) freigegeben wird, woraufhin der Bestückungsroboter (4) mit dem Greifer (9) ein Werkzeuggerät (11), etwa einen elektrisch angetriebenen Schrauber oder ein Nietgerät, von einer Geräteabnahmeposition abnimmt, indem der Bestückungsroboter (4) das Werkzeuggerät (11) mit dem Greifer (9) greift oder über ein Wechselsystem, wie zum Beispiel eine Schnellwechselkupplung, aufnimmt und mindestens einer Befestigungsposition auf der Montageplatte (1) zuführt, wozu der Bestückungskomponente (2) zugeordnete Montagepositionsdaten aus den Planungsdaten extrahiert werden.

10. Verfahren nach einem der Ansprüche 4 bis 9, bei dem das Bereitstellen mindestens einer der in der Stückliste enthaltenen Bestückungskomponenten (2) das Bereitstellen einer Montageschiene (16) aufweist, die mit dem Bestückungsroboter (4) von der Komponentenzuführung abgenommen, an einer Montageposition auf der Montageplatte (1) platziert und an der Montageposition auf der Montageplatte (1) montiert wird, wobei anschließend daran mindestens eine weitere in der Stückliste enthaltene Bestückungskomponente (2) von dem Bestückungsroboter (4) von der Komponentenzuführung abgenommen und an der auf der Montageplatte (1) montierten Montageschiene (16) montiert, vorzugsweise auf der Montageschiene (16) aufgerastet wird.

11. Verfahren nach Anspruch 10, bei dem der weiteren Bestückungskomponente (2) zugeordnete weitere Montagepositionsdaten aus den Planungsdaten extrahiert werden, die eine Montageposition der weiteren Bestückungskomponente (2) entlang der Montageschiene (16) vorgeben, wobei für das Montieren der weiteren Bestückungskomponente (2) an der Montageschiene (16) aus den Planungsdaten der Bestückungskomponente (2) zugeordnete Bewegungsdaten extrahiert werden, durch die eine von dem Bestückungsroboter (4) auszuführende Montagebewegung für das Montieren der weiteren Bestückungskomponente (2) an der Montageschiene (16) vorgegeben ist.

12. Verfahren nach einem der vorangegangenen Ansprüche, bei dem die Bestückungskomponente (2) als Stangen- oder Endlosware bereitgestellt ist, wobei das Verfahren das Ablängen der Bestückungskomponente (2) aufweist, wozu aus den Planungsdaten Längendaten für eine auf der Montageplatte (1) zu montierende Bestückungskomponente (2) extrahiert werden, und wobei die Bestückungskomponente (2) nach dem Ablängen an einer Komponentenzuführung, die im Zugriffsbereich des Bestückungsroboters (4) angeordnet ist, für das Abnehmen durch den Bestückungsroboter (4) bereitgestellt wird.

13. Verfahren nach einem der vorangegangenen Ansprüche, bei dem nach dem Ausführen des mindestens einen Bearbeitungs- oder Bestückungsschrittes sowie einer diesbezüglichen Qualitätskontrolle ein Ergebnis der Qualitätskontrolle in den Planungsdaten hinterlegt und über die Positionsdaten der Planungsdaten eindeutig der Bestückungskomponente (2) oder der Bearbeitungsposition zugeordnet wird.

14. Verfahren nach einem der vorangegangenen Ansprüche, bei dem sämtliche das Abnehmen durch den Bestückungsroboters (4) betreffenden Verfahrensschritte während des gesamten Verfahrens mit demselben Endeffektor (10) und Greifer (9) des Bestückungsroboters (4) durchgeführt werden, wozu zwei zueinander verstellbare Greiferbacken (12), vorzugsweise zwei linear zueinander verstellbare plattenförmige Greiferbacken (12), das jeweils abzunehmende Element (2, 11) durch Verstellen der Greiferbacken (12) einklemmen und wozu das abzunehmende Element (2, 11) mit einem Adapter (20) in einen Griffbereich der zueinander verstellbaren Greiferbacken (12) eingreift.

## Claims

1. A method for populating a mounting board (1) with assembly components (2) of a switchgear and/or control system, the method comprising the steps of:
- reading planning data of a switchgear and/or control system into an assembly machine (3) comprising an assembly robot (4);
- extracting position data of at least one assembly component (2) to be mounted on the mounting board (1) and/or at least one processing position of the mounting board (1) from the planning data;
- detecting a spatial orientation and/or a position of the mounting board (1) with an image processing system (5) of the assembly robot (4);
- assigning the position data to at least one position on the mounting board (1); and
- carrying out at least one processing or assembly step linked via the planning data to the position on the mounting board (1) at the position on the mounting board (1) with the assembly robot (4),
wherein the detecting comprises detecting an orientation and/or a position of at least one borehole (6), at least one borehole image (7), or at least one breakout (8) in the mounting board (1) and comparing at least one orientation and/or position detected in the process with a target specification extracted from the planning data,
**characterised in that**
at least one borehole (6), at least one borehole image (7), or at least one breakout (8) is introduced into the mounting board (1) with the assembly robot (4) if, in contrast to the target specification, at least one missing borehole (6), at least one missing borehole image (7), or at least one missing breakout (8) has been detected during the comparison.

2. The method according to claim 1, which comprises introducing at least one borehole (6), at least one borehole image (7), or at least one breakout (8) into the mounting board (1) with the assembly robot (4), for which purpose the assembly robot (4) removes a tool device (11) from a reference position assigned to the mounting board (1) with a gripper (9) on its end effector (10).

3. The method according to claim 2, in which the assembly robot (4) feeds the tool device (11) removed from the reference position to a position on the mounting board (1) to which at least one processing step is assigned via the planning data, preferably introducing at least one borehole (6), at least one borehole image (7), or at least one breakout (8) into the mounting board (1), and in which the assembly robot (4) carries out the at least one processing step with the tool device (11).

4. The method according to one of the preceding claims, which comprises extracting a parts list of assembly components (2) from the planning data and providing at least one of the assembly components (2) contained in the parts list on a component feed which is arranged in the access region of the assembly robot (4).

5. The method according to claim 4, which comprises picking up the assembly component (2) from the access region with a gripper (9) on the end effector (10) of the assembly robot (4) and marking the picked-up assembly component (2) with a unique marking which is extracted from the planning data, preferably from the parts list.

6. The method according to claim 4 or 5, in which providing at least one of the assembly components (2) contained in the parts list comprises providing a plurality of identical assembly components (2), of which only one is picked up by the assembly robot (4) and marked with a unique marking.

7. The method according to claim 5 or 6, in which the marking comprises placing the assembly component (2) on a marking unit (14) with the assembly robot (4) and optically readable marking the assembly component (2) with the marking unit (14) and after the marking, picking up the assembly component (2) again with the assembly robot (4) from the marking unit (14).

8. The method according to one of claims 5 to 7, in which the assembly component (2) is placed on the mounting board (1) after the provision, picking up and marking by the assembly robot (4), for which purpose position data assigned to the assembly component (2) are extracted from the planning data via the unique marking.

9. The method according to claim 8, in which the assembly component (2) is released after the placement of the gripper (9) on the end effector (10) of the assembly robot (4), whereupon the assembly robot (4) removes a tool device (11), such as an electrically driven screwdriver or a riveting device, from a device pick-up position with the gripper (9) by the assembly robot (4) gripping the tool device (11) with the gripper (9) or picking it up via a change system, such as a quick-change coupling, and feeding it to at least one fastening position on the mounting board (1), for which purpose mounting position data assigned to the assembly component (2) are extracted from the planning data.

10. The method according to one of claims 4 to 9, in which the provision of at least one of the assembly components (2) contained in the parts list comprises providing a mounting rail (16) which is removed from the component feed with the assembly robot (4), placed at a mounting position on the mounting board (1) and mounted at the mounting position on the mounting board (1), wherein subsequently at least one further assembly component (2) contained in the parts list is removed from the component feed by the assembly robot (4) and mounted on the mounting rail (16) mounted on the mounting board (1), preferably snapped onto the mounting rail (16).

11. The method according to claim 10, in which further mounting position data assigned to the further assembly component (2) are extracted from the planning data which specify a mounting position of the further assembly component (2) along the mounting rail (16), wherein movement data assigned to the assembly component (2) for the mounting of the further assembly component (2) on the mounting rail (16) are extracted from the planning data, by which movement data a mounting movement to be carried out by the assembly robot (4) is specified for the mounting of the further assembly component (2) on the mounting rail (16).

12. The method according to one of the preceding claims, in which the assembly component (2) is provided as a rod or continuous product, wherein the method comprises cutting to length the assembly component (2), for which purpose length data for an assembly component (2) to be mounted on the mounting board (1) are extracted from the planning data, and wherein the assembly component (2) is provided for the removal by the assembly robot (4) after the cutting to length on a component feed which is arranged in the access region of the assembly robot (4).

13. The method according to one of the preceding claims, in which after the carrying out of the at least one processing or assembly step and a related quality control a result of the quality control is stored in the planning data and uniquely assigned to the assembly component (2) or the processing position via the position data of the planning data.

14. The method according to one of the preceding claims, in which all method steps relating to the removal by the assembly robot (4) are carried out during the entire method with the same end effector (10) and gripper (9) of the assembly robot (4), for which purpose two mutually adjustable gripper jaws (12), preferably two linearly mutually adjustable plate-shaped gripper jaws (12), clamp the respective element (2, 11) to be removed by adjusting the gripper jaws (12) and for which purpose the element (2, 11) to be removed engages with an adapter (20) in a gripping region of the mutually adjustable gripper jaws (12).

## Revendications

1. Procédé d'équipement d'une plaque de montage (1) avec des composants d'équipement (2) d'une installation de commutation et/ou de commande, qui comprend les étapes suivantes :
- importation des données de planification d'une installation de commutation et/ou de commande dans un automate d'équipement (3), qui comprend un robot d'équipement (4) ;
- extraction de données de position d'au moins un composant d'équipement (2) à monter sur la plaque de montage (1) et/ou d'au moins une position de traitement de la plaque de montage (1), des données de planification ;
- détection d'une orientation et/ou d'une position dans l'espace de la plaque de montage (1) avec un système de traitement d'image (5) du robot d'équipement (4) ;
- mise en correspondance des données de position avec au moins une position sur la plaque de montage (1) ; et
- exécution d'au moins une étape de traitement ou d'équipement associée, par l'intermédiaire des données de planification, à la position sur la plaque de montage (1), au niveau de la position sur la plaque de montage (1) avec le robot d'équipement (4), dans lequel la détection comprend la détection d'une orientation et/ou d'une position d'au moins un perçage (6), d'au moins un gabarit de perçage (7) ou d'au moins une découpe (8) dans la plaque d montage (1) et la comparaison d'au moins une orientation et/ou position détectée avec une consigne extraite des données de planification, **caractérisé en ce que**
au moins un perçage (6), au moins un gabarit de perçage (7) ou au moins une découpe (8) est réalisée avec le robot d'équipement (4) dans la plaque de montage (1) lorsque, lors de la comparaison avec la consigne, un perçage (6) manquant, un gabarit de perçage (7) manquant ou une découpe (8) manquante a été détecté.

2. Procédé selon la revendication 1, qui comprend la réalisation d'au moins un perçage (6), d'au moins un gabarit de perçage (7) ou d'au moins une découpe (8) dans la plaque de montage (1) avec le robot d'équipement (4), le robot d'équipement (4) déplaçant, pour cela, avec une pince (9) au niveau de son effecteur d'extrémité (10), un outil (11) à partir d'une position de référence sur la plaque de montage (1).

3. Procédé selon la revendication 2, dans lequel le robot d'équipement (4) amène l'outil (11) déplacé de la position de référence vers une position sur la plaque de montage (1), avec laquelle au moins une étape de traitement est mise en correspondance par l'intermédiaire des données de planification, de préférence la réalisation d'au moins un perçage (6), d'au moins un gabarit de perçage (7) ou d'au moins une découpe (8) dans la plaque de montage (1) et dans lequel le robot d'équipement (4) exécute, avec l'outil (11) l'au moins une étape de traitement.

4. Procédé selon l'une des revendications précédentes, qui comprend l'extraction d'une liste de composants d'équipement (2) des données de planification et la mise à disposition d'au moins un des composants d'équipement (2) contenus dans la liste au niveau d'une alimentation en composants, qui est disposée dans la zone d'accès du robot d'équipement (4).

5. Procédé selon la revendication 4, qui comprend la prise en charge du composant d'équipement (2) dans la zone d'accès avec une pince (9) sur l'effecteur d'extrémité (10) du robot d'équipement (4) et l'identification du composant d'équipement (2) pris en charge avec un identifiant unique qui est extrait des données de planification, de préférence de la liste de pièces.

6. Procédé selon la revendication 4 ou 5, dans lequel la mise à disposition d'au moins un des composants d'équipement (2) contenus dans la liste comprend la mise à disposition d'une pluralité de composants d'équipement (2) similaires, dont un seul est pris en charge par le robot d'équipement (4) et identifié avec un identifiant unique.

7. Procédé selon la revendication 5 ou 6, dans lequel l'identification comprend le dépôt du composant d'équipement (2) sur une unité de marquage (14) avec le robot d'équipement (4) et le marquage optiquement lisible du composant d'équipement (2) avec l'unité de marquage (14) et, après le marquage, la reprise en charge du composant d'équipement (2) avec le robot d'équipement (4) dans l'unité de marquage (14).

8. Procédé selon l'une des revendications 5 à 7, dans lequel le composant d'équipement (2) est placé, après la mise à disposition, la prise en charge et l'identification, par le robot d'équipement (4) sur la plaque de montage (1), des données de position étant pour cela extraites des données de planification grâce à l'identifiant unique du composant d'équipement (2).

9. Procédé selon la revendication 8, dans lequel le composant d'équipement (2), après le placement par la pince (9) sur l'effecteur d'extrémité (10) du robot d'équipement (4), est libéré, le robot d'équipement (4) déplaçant alors, avec la pince (9), un outil (11), par exemple une visseuse ou une riveteuse électrique, à partir d'une position de retrait d'appareil, le robot d'équipement (4) saisissant pour cela l'outil (11) avec la pince (9) ou le prenant en charge par l'intermédiaire d'un système de changement, par exemple un couplage rapide et l'amenant vers au moins une position de fixation sur la plaque de montage (1), les données de position de montage correspondant au composant d'équipement (2) étant pour cela extraites des données de planification.

10. Procédé selon l'une des revendications 4 à 9, dans lequel la mise à disposition d'au moins un des composants d'équipement (2) contenus dans la liste comprend la mise à disposition d'un rail de montage (16) qui est retiré par le robot d'équipement (4) de l'alimentation en composants, placé au niveau d'une position de montage sur la plaque de montage (1) et monté à la position de montage sur la plaque de montage (1), dans lequel au moins un autre composant d'équipement (2) contenu dans la liste est ensuite retiré par le robot d'équipement (4) de l'alimentation en composants et est monté sur le rail de montage (16) monté sur la plaque de montage (1), de préférence est encliqueté sur le rail de montage (16).

11. Procédé selon la revendication 10, dans lequel d'autres données de positions de montage correspondant à un autre composant d'équipement (2) sont extraites des données de planification, qui indiquent une position de montage de l'autre composant d'équipement (2) le long du rail de montage (16), dans lequel, pour le montage de l'autre composant d'équipement (2) sur le rail de montage (16), des données de déplacement correspondant au composant d'équipement (2) sont extraites des données de planification, grâce auxquelles un déplacement de montage à exécuter par le robot d'équipement (4) est prédéfini pour le montage de l'autre composant d'équipement (2) sur le rail de montage (16).

12. Procédé selon l'une des revendications précédentes, dans lequel le composant d'équipement (2) est mis à disposition sous la forme d'un article de type tige ou sans fin, dans lequel le procédé comprend la découpe à la longueur du composant d'équipement (2), des données de longueur pour un composant d'équipement (2) à monter sur la plaque de montage (1) étant pour cela extraites des données de planification et dans lequel le composant d'équipement (2), après la découpe à la longueur, sur une alimentation en composants, qui est disposée dans une zone d'accès du robot d'équipement (4), est mis à disposition pour le retrait par le robot d'équipement (4).

13. Procédé selon l'une des revendications précédentes, dans lequel, après l'exécution de l'au moins une étape de traitement ou d'équipement et d'un contrôle qualité correspondant, un résultat du contrôle qualité est enregistré dans les données de planification et est mis en correspondance, de manière unique, par l'intermédiaire des données de position des données de planification, avec le composant d'équipement (2) ou la position de traitement.

14. Procédé selon l'une des revendications précédentes, dans lequel toutes les étapes concernant le retrait par le robot d'équipement (4) sont effectuées pendant tout le procédé avec le même effecteur d'extrémité (10) et la même pince (9) du robot d'équipement (4), deux mâchoires de pinces (12) mobiles l'une par rapport à l'autre, de préférence deux mâchoires de pinces (12) en forme de plaques mobiles linéairement l'une par rapport à l'autre, serrent l'élément à retirer (2, 11) par le déplacement des mâchoires de pince (12) et l'élément à retirer (2, 11) s'emboîte avec un adaptateur (20) dans une zone de préhension des mâchoires de pinces (12) mobiles l'une par rapport à l'autre.
